# DEMANDE DE BREVET EUROPEEN

(11) **EP 4 525 594 A1**
(43) Date de publication de la demande: **19.03.2025**
(21) Numéro de dépôt: 24199322.9
(22) Date de dépôt: 09.09.2024
(51) Int. Cl.: H10K 71/16, H10K 85/50, H10K 30/40

(54) **PROCEDE D'ELABORATION D'UNE COUCHE DE PEROVSKITE HYBRIDE ORGANIQUE-INORGANIQUE**

(30) Priorité: 12.09.2023 GR 20230100731; 12.10.2023 FR 2310971
(71) Demandeur: Commissariat à l'Energie Atomique et aux Energies Alternatives, 75015 Paris (FR)
(72) Inventeur: GRENET, Louis, 38054 GRENOBLE CEDEX 09 (FR); TESTARD, Elodie, 38054 GRENOBLE CEDEX 09 (FR); ROUX, Frédéric, 38054 GRENOBLE CEDEX 09 (FR); BERSON, Solenn, 38054 GRENOBLE CEDEX 09 (FR); TSOULKA, Polyxeni, 38054 GRENOBLE CEDEX 09 (FR)
(74) Mandataire: Cabinet Beaumont

(57) **Abrégé**

La présente description concerne un procédé d'élaboration d'une couche de matériau pérovskite hybride organique-inorganique comprenant les étapes suivantes :
a) Formation d'une couche (11) comprenant les précurseurs inorganiques du matériau pérovskite sur un substrat (10) par CSS ou CSVTD,
b) Mise en oeuvre d'une étape de CSS ou de CSVTD à partir de précurseurs organiques (22, 24), moyennant quoi les précurseurs organiques (22, 24) réagissent avec la couche (11) de précurseurs inorganiques et on obtient une couche (12) de matériau pérovskite hybride organique-inorganique.

## Description

### Domaine technique

La présente description concerne de façon générale le domaine des pérovskites hybrides organiques-inorganiques, et plus particulièrement leur procédé d'élaboration.

L'invention trouve des applications dans de nombreux domaines industriels, en particulier dans le domaine du photovoltaïque, ou encore pour la fabrication de dispositifs électroniques, optiques ou optoélectroniques, en particulier pour la fabrication de diodes électroluminescentes (DEL), de photo-détecteurs, de scintillateurs, de détecteur de rayons X, par exemple pour le médical, ou encore de transistors.

L'invention est particulièrement intéressante puisqu'elle permet de former des couches de pérovskites de composition contrôlée avec des temps de dépôt relativement courts, compatibles avec une mise en oeuvre à grande échelle.

### Technique antérieure

Les pérovskites hybrides organiques-inorganiques sont des matériaux particulièrement intéressants pour les cellules photovoltaïques, et notamment pour les cellules photovoltaïques tandem sur silicium.

Parmi les matériaux hybrides organiques-inorganiques particulièrement prometteurs, on peut citer les matériaux de type ABX₃ avec A représentant un cation ou un mélange de cations choisis parmi Cs⁺, FA⁺ (avec FA= CH₅N2), MA⁺ (avec MA = CH₃-NH₃), B un cation métallique choisi parmi Pb, Sn, Ge et X un halogène choisi parmi Cl, Br et I.

Généralement, les procédés d'élaboration de couches de pérovskites hybrides sont réalisés en deux étapes : la partie inorganique de la pérovskite est déposée en premier puis la partie organique est ajoutée.

Par exemple, dans l'article de Zhang et al. (ACS Appl. Energy Mater. 2022, 5, 5797-5803) des films de Cs_{0.14}FA_{0.86}Pb(BrₓI_{1 -x})₃ sont également obtenus en mettant en oeuvre un procédé en deux étapes. Dans un premier temps, des couches inorganiques de CSI et PbI₂ sont déposées de manière séquentielle sur un substrat. Dans un deuxième temps, un film organique de FAI ou un film organique de FAI/FABr est préparé en déposant sur un substrat les précurseurs organiques par une pulvérisation d'une solution d'éthanol comprenant lesdits précurseurs. Ce film est utilisé pour mettre en oeuvre une étape de sublimation à faible distance (ou CSS pour « Close Space Sublimation ») à une température de 160°C. Lors de cette étape, le matériau est sublimé, ce qui permet de faire réagir les vapeurs organiques avec les couches de CSI et PbI₂ et ainsi former le matériau pérovskite.

Cependant, le procédé synthèse décrit nécessite une première étape de dépôt des précurseurs inorganiques qui est généralement faite par voie liquide ou par co-évaporation. Dans ces 2 cas, la méthode de dépôt des précurseurs inorganique pose de sérieux verrous pour l'industrialisation, notamment en ce qui concerne le cadencement de production, l'homogénéité de dépôt sur de grandes surfaces, la possibilité de dépôt sur substrats texturés, ou encore la gestion des effluents liquides.

### Résumé de l'invention

Il existe un besoin d'obtenir un procédé permettant de former une couche de pérovskite hybride organique-inorganique dont la composition est contrôlée et permettant de former une telle couche, sur de grandes surfaces (typiquement supérieures à 20x 20 cm²) et/ou sur des substrats texturés (par exemple pour des plaques, notamment en silicium, présentant en surface une texture de pyramides ayant, notamment, une hauteur supérieure à 1 pm) avec une cadence élevée de manière à pouvoir être industrialisé.

Ce but est atteint par un procédé d'élaboration d'une couche de matériau pérovskite hybride organique-inorganique comprenant les étapes suivantes :
a) Formation d'une couche comprenant les précurseurs inorganiques du matériau pérovskite sur un substrat par CSS ou par CSVTD,
b) Mise en oeuvre d'une étape de CSS ou de CSVTD à partir de précurseurs organiques, moyennant quoi les précurseurs organiques réagissent avec les précurseurs inorganiques présents dans la couche et on obtient une couche de matériau pérovskite hybride organique-inorganique.

L'invention se distingue fondamentalement de l'art antérieur par la mise en oeuvre d'un procédé d'élaboration en deux étapes, l'étape a) et l'étape b) pouvant être indépendamment l'une de l'autre mises en oeuvre par sublimation à faible distance (CSS ou "Close-Spaced Sublimation") ou par dépôt par transport de vapeur à faible distance (CSVTD ou "Close-Spaced Vapor Transport Déposition", aussi parfois noté CSVT). La CSVTD est aussi parfois appelée transport chimique en phase vapeur à courte distance.

L'étape de CSS consiste à sublimer un matériau solide, la distance entre le substrat et le matériau à sublimer étant faible. Par faible distance, on entend une distance comprise entre 0,1 et 10 mm, de préférence entre 0,1 et 5 mm.

L'étape de CSVTD consiste, quant à elle, à sublimer un matériau solide ou à évaporer un matériau liquide. Le matériau solide ou liquide est par exemple positionné dans un creuset qui est chauffé. Cette étape est aussi réalisée à faible distance (par exemple de l'ordre du millimètre).

La CSVTD permet, tout comme la CSS, d'avoir une vitesse de dépôt élevé, une faible perte de matière et une grande homogénéité des couches.

La première étape (étape a) par CSS ou CSVTD permet de former une couche comprenant les précurseurs inorganiques du matériau pérovskite. La deuxième étape (étape b) par CSS ou CSVTD permet d'imprégner la couche préalablement déposée avec les précurseurs organiques du matériau pérovskite. Cette imprégnation résulte de la réaction des précurseurs inorganiques avec la phase gazeuse issue de l'évaporation ou de la sublimation des précurseurs organiques. Lors de l'étape b), les précurseurs organiques sont sous forme gazeuse. Cette imprégnation conduit à la formation du matériau final.

Ces méthodes de sublimation ou d'évaporation sont particulièrement intéressantes d'un point de vue industriel car elles permettent de former rapidement des couches en matériau pérovskite de composition contrôlée.

Par exemple, les vitesses de dépôt par CSS et CSVTD peuvent être supérieures à 100 nm/min ou même supérieures à 1000 nm/min. A titre illustratif, les vitesses de dépôt par évaporation sont de l'ordre de 10 nm/min.

Avantageusement, la pérovskite hybride organique-inorganique a pour formule A'₁₋ₓAₓBX₃ avec _{:}
A' un cation inorganique ou un alliage de cations inorganiques, de préférence choisis parmi Cs, Rb, K et Na,
A un cation organique monovalent ou un alliage de cations organiques monovalents, de préférence choisis parmi le méthylammonium (MA), le formamidinium (FA), le guanidinium (GA), le diméthylammonium (DA) et l'imidazolium (IA), encore plus préférentiellement A correspond à MA et/ou FA,
B un cation inorganique ou un alliage de cations inorganiques, de préférence choisis parmi Pb, Sn et Ge,
X un ou plusieurs halogènes, de préférence choisis parmi Cl, Br, I et F.

Avantageusement, la pérovskite hybride organique-inorganique a pour formule Cs₁₋ₓMAₓPb(I_{1-y}Br_{y})₃, Cs₁₋ₓFAₓPb(I_{1-y-z}Br_{y}C_{lz})₃ ou Cs₁₋ₓFAₓPb(I_{1-y}Br_{y})₃, Cs₁₋ₓFAₓPb_{0.5}Sn_{0.5}(I_{1-y}Br_{y})₃, Cs_{1-x-z}MAₓFA_{z}Pb(I_{1-y}Br_{y})₃ ou Cs₁₋ₓ₋₂MAₓFA₂Pb₁₋ₖSnₖI_{1-y}Br_{y})₃ avec 0 ≤ y ≤ 1, 0 ≤ k ≤ 1, 0 ≤ x ≤ 1, 0 ≤ z ≤ 1 et 0 ≤ x+z ≤ 1, et de préférence 0 < y < 1 et 0 < x < 1.

Avantageusement, la couche comprenant les précurseurs inorganiques est une couche contenant du Pb, du Cs et un ou plusieurs halogènes choisis parmi l'iode, le brome et le chlore. Avantageusement, la couche de précurseurs inorganiques est une couche de PbI₂ et de CsI, une couche de PbI₂ et de CsBr, une couche de PbBr₂ et de CsI, une couche de PbBr₂ et de CsBr, une couche de PbI₂, PBBr₂ et CSI, une couche de PbI₂, PBBr₂ et CSBr, une couche de PbI₂, CSI et CsBr, une couche de PbBr₂, CSI et CsBr ou une couche de PbBr₂, PbI₂, CSI et CsBr.

Avantageusement, les précurseurs organiques sont FA(I_{1-y}Br_{y}) ou MA(I_{1-y}Br_{y}) avec 0 ≤ y ≤ 1 et, de préférence, 0 < y < 1.

Selon une première variante de réalisation avantageuse, l'étape a) et l'étape b) sont réalisées par CSS.

Selon cette première variante de réalisation avantageuse, l'étape a) et/ou l'étape b) peut être réalisée par CSS à partir d'une poudre de précurseurs obtenue par mécanosynthèse.

Par exemple, l'étape b) peut être réalisée par CSS à partir d'une poudre de précurseurs organiques, la poudre de précurseurs organiques est obtenue par mécanosynthèse en cobroyant au moins un premier groupe de particules en un premier matériau et un deuxième groupe de particules en un deuxième matériau, jusqu'à former un troisième groupe de particules en un troisième matériau, le troisième groupe de particules formant la poudre de précurseurs organiques.

L'étape a) peut aussi être réalisée de la sorte par mécanosynthèse en cobroyant différents groupes de particules en différents matériaux pour obtenir la poudre de précurseurs inorganiques, formées de particules, de préférence monophasées, chaque particule ayant la composition que l'on souhaite faire réagir ultérieurement avec les précurseurs organiques.

Selon une deuxième variante de réalisation avantageuse, l'étape a) et l'étape b) sont réalisées par CSVTD.

Avantageusement, le substrat est un substrat adapté au domaine photovoltaïque. Par exemple, il peut s'agir d'un substrat en verre, en plastique ou en métal.

Avantageusement, le substrat est un substrat en silicium, de préférence un substrat en silicium texturé. Un tel substrat est particulièrement intéressant pour former un dispositif photovoltaïque.

L'invention concerne également un procédé de fabrication d'une cellule photovoltaïque multi-jonction comprenant au moins une cellule photovoltaïque en pérovskite ou d'une cellule photovoltaïque pérovskite à simple jonction, le procédé comprenant l'élaboration d'une couche de pérovskite organique-inorganique selon le procédé tel que décrit précédemment.

La cellule photovoltaïque multi-jonction comprenant au moins une cellule photovoltaïque en pérovskite est, par exemple, une cellule photovoltaïque tandem pérovskite-silicium, une cellule photovoltaïque tandem pérovskite-pérovskite, une cellule photovoltaïque triple jonction pérovskite-pérovskite-silicium ou une cellule photovoltaïque triple jonction pérovskite-pérovskite-pérovskite

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et le figure 1B représentent de manière schématique différentes étapes d'un procédé d'élaboration d'une couche de pérovskite organique inorganique selon un mode de réalisation particulier de l'invention ;
la figure 2A et la figure 2B représentent de manière schématique différentes étapes d'un procédé d'élaboration d'une couche de pérovskite organique inorganique selon un autre mode de réalisation particulier de l'invention ;
la figure 3 représente de manière schématique et en coupe un four de sublimation à faible distance selon un mode de réalisation particulier de l'invention ;
la figure 4A et la figure 4B sont des représentations schématiques et en coupe, respectivement, d'une cellule photovoltaïque simple jonction et d'une cellule photovoltaïque tandem, selon différents modes de réalisation particulier de l'invention ;
la figure 5A est un cliché obtenu au microscope électronique à balayage d'une couche de précurseurs inorganiques obtenue selon un mode de réalisation particulier de l'invention ;
la figure 5B est un cliché obtenu au microscope électronique à balayage d'une couche de pérovskite hybride organique-inorganique obtenue à partir de la couche de précurseurs inorganiques de la figure 4A, selon un mode de réalisation particulier de l'invention ;
la figure 6 est un graphique représentant un diffractogramme des Rayons X d'une couche de pérovskite organique-inorganique, selon un mode de réalisation particulier de l'invention ;
la figure 7 est un cliché obtenu au microscope électronique à balayage d'une couche de pérovskite déposée sur un substrat en silicium texturé, selon un mode de réalisation particulier de l'invention ;
la figure 8 est une courbe courant-tension, sous un éclairement AM1, 5 à t=0 et à t=24h et dans le noir, d'une cellule photovoltaïque comprenant une couche de pérovskite organique-inorganique obtenue selon un mode de réalisation particulier de l'invention ;
la figure 9 est une courbe courant-tension sous un éclairement AM1,5 d'une cellule photovoltaïque comprenant une couche de pérovskite organique-inorganique obtenue selon un autre mode de réalisation particulier de l'invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

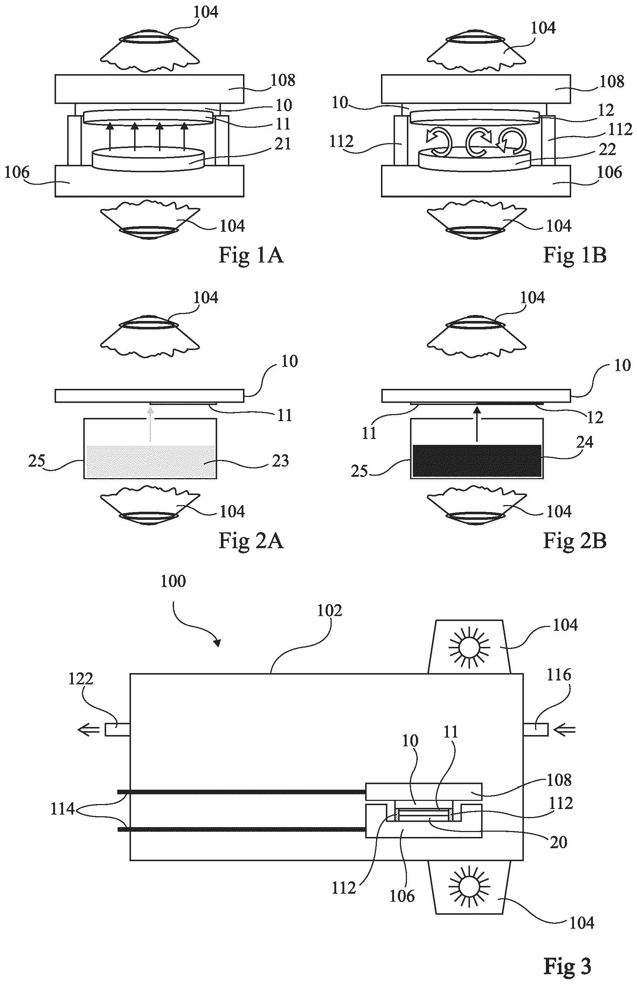

Le procédé que nous allons par la suite décrire plus en détail, en faisant référence aux figures 1A et 1B ainsi qu'aux figures 2A et 2B, concerne l'élaboration d'une couche de pérovskite hybride organique-inorganique.

La pérovskite hybride organique-inorganique a, de préférence, pour formule générale A'₁₋ₓAₓBX₃ avec :
A' un cation inorganique ou un alliage de cations inorganiques, de préférence choisis parmi Cs⁺, Rb⁺, K⁺ et Na⁺,
A un cation organique monovalent ou un alliage de cations organiques monovalents, choisis parmi CH₃NH₃⁺ (méthylammonium MA), CH(NH₂)₂⁺ (formamidinium ou FA)), C(NH₂)₃⁺(guanidinium ou GA), C₂H₈N (diméthylammonium ou DA), C₃H₅N₂ (imidazolium ou IA) ; un alliage de cations organiques monovalents peut être, par exemple, MA₁₋ₓFAₓ avec 0<x<1),
B un cation inorganique ou un alliage de cations inorganiques, de préférence choisis parmi Pb²⁺, Sn²⁺ et Ge²⁺,
X un anion ou alliage d'anions halogènes, de préférence choisis parmi Cl, Br, I et F.

De préférence, A' représente Cs.

De préférence, A représente MA et/ou FA.

De préférence, B représente Pb, Sn et Ge,

De préférence, X représente Br et/ou I.

Avantageusement, la pérovskite hybride organique-inorganique a pour formule Cs₁₋ₓMAₓPb(I_{1-y}Br_{y})₃, Cs₁₋ₓFAₓPb(I_{1-y-z}Br_{y}Cl_{z})₃ ou Cs₁₋ₓFAₓPb(I_{1-y}Br_{y})₃ ou Cs₁₋ₓFAₓPb_{0.5}Sn_{0.5}(I_{1-y}Br_{y})₃ ou Cs_{1-x-z}MAₓFA_{z}Pb(I_{1-y}Br_{y})₃ ou Cs_{1-x-z}MAₓFA_{z}Pb₁₋ₖSnₖI_{1-y}Br_{y})₃ avec 0 ≤ y ≤ 1 , 0 ≤ k ≤ 1, 0 ≤ x ≤ 1, 0 ≤ z ≤ 1 et 0 ≤ x+z ≤ 1, et de préférence 0 < y < 1 et 0 < x < 1.

Le procédé comprend les étapes suivantes :
a) Formation d'une couche 11 sur un substrat 10, par CSS ou CSVTD, en sublimant ou en évaporant les précurseurs inorganiques 21, 23 du matériau pérovskite, moyennant quoi on forme une couche 11 comprenant, et, de préférence, constituée, des précurseurs inorganiques (figures 1A ou 2A),
b) Sublimation ou évaporation, par CSS ou CSVTD, de précurseurs organiques 22, 24 du matériau pérovskite, moyennant quoi les précurseurs organiques, sous forme gazeuse, réagissent avec les précurseurs inorganiques présent dans la couche 11 formée à l'étape a) et on obtient une couche 12 matériau pérovskite hybride organique-inorganique (figures 2A ou 2B).

Il est possible de mettre en oeuvre l'une des quatre variantes de réalisation :
- mise en oeuvre de l'étape a) par CSS et mise en oeuvre de l'étape b) par CSVTD,
- mise en oeuvre de l'étape a) par CSS et mise en oeuvre de l'étape b) par CSS,
- mise en oeuvre de l'étape a) par CSVTD et mise en oeuvre de l'étape b) par CSS,
- mise en oeuvre de l'étape a) par CSVTD et mise en oeuvre de l'étape b) par CSVTD.

Selon une variante particulièrement avantageuse, l'étape a) et l'étape b) sont mises en oeuvre par CSS (figures 1A et 1B).

Dans le cas d'un dépôt par CSS, les précurseurs 21, 22 sont à l'état solide, de préférence, sous forme d'une poudre.

La poudre peut former un lit de particules.

Alternativement, les particules peuvent être agglomérées pour former une cible solide (aussi appelée galette). La poudre peut être compactée par exemple au moyen d'une presse hydraulique. Pour cela, la poudre est pressée, par exemple avec une presse hydraulique avec P ~ 1×10⁷ Pa). Le pressage de la cible peut se faire en chauffant la poudre.

La poudre de précurseurs 21, 22 utilisée peut comprendre, par exemple, un premier groupe de particules en un premier matériau et un deuxième groupe de particules en un deuxième matériau.

Selon un mode de réalisation avantageux, la poudre de précurseurs 21, 22 est obtenue par mécanosynthèse, en cobroyant au moins un premier groupe de particules en un premier matériau et un deuxième groupe de particules en un deuxième matériau, jusqu'à former un troisième groupe de particules en un troisième matériau.

Le troisième groupe de particules forme la poudre de précurseurs inorganiques 21 (étape a)) ou la poudre de précurseurs organiques 22 (étape b)).

La mécanosynthèse consiste à réaliser un co-broyage très énergétique des matériaux purs ou pré-alliés dans un broyeur à haute énergie jusqu'à l'obtention d'une poudre dont les particules sont monophasées ou polyphasées. De préférence les particules sont monophasées.

Le cobroyage est réalisé avec au moins deux groupes de particules. Il pourrait également être mis en oeuvre avec plus de deux groupes de particules (par exemple trois ou quatre groupes de particules).

Le co-broyage est réalisé dans un broyeur planétaire à billes. La masse de billes est au moins deux fois supérieure à la masse de poudres, par exemple au moins 15 fois supérieure.

La vitesse de rotation du broyage est élevée (typiquement de 100 tours/min à 700 tours/min, par exemple 500 tours/min) . Elle dépend du broyeur utilisé ainsi que de la masse de billes et de poudres. Le temps de broyage est par exemple entre 10min et 5h, par exemple 1h.

Le mélange peut être un mélange équimolaire.

Ce mode de réalisation est particulièrement avantageux car il permet d'avoir directement la bonne composition et la bonne phase du matériau à sublimer.

Selon une autre variante de réalisation, pour mettre en oeuvre l'étape a) et/ou l'étape b) par CSS, les précurseurs peuvent être sous la forme d'une couche préalablement déposée sur un autre substrat. Une telle couche peut être, par exemple, formée par une méthode de dépôt sous vide (évaporation ou pulvérisation cathodique notamment) ou par une méthode de dépôt par voie liquide (par exemple par dépôt à la tournette, aussi appelé « spin coating », ou encore par revêtement par dépôt par filière plate, aussi appelé « slot-die »). Il est également possible de former un monocristal du matériau à déposer (plaquette ou « wafer », lingot découpé, etc).

Lors de l'étape a) par CSS, le transfert de matière entre les précurseurs 21 et le substrat 10 a lieu sur une distance très faible (entre 0,1 et 10 mm, avantageusement 5 mm). Les précurseurs 21 sont avantageusement disposés de manière à avoir la même forme géométrique et la même surface que le substrat 10 sur lequel on souhaite déposer les précurseurs. Ainsi, les précurseurs inorganiques 21 se subliment et se déposent sur le substrat 10 (flèche sur la figure 1A).

Lors de l'étape b) par CSS, les précurseurs passent d'un état solide à un état gazeux (représenté par des flèches sur la figure 1B). Les précurseurs 22 peuvent donc être mis en forme sous une forme peut être identique ou différente de celle du substrat 10 recouvert par la couche 11 de précurseurs inorganiques.

Lors de l'étape b) par CSS, seule la composition de la cible est importante. Avantageusement, la composition de la cible peut être identique à la composition de la phase gazeuse que l'on souhaite faire réagir avec la couche de précurseurs inorganiques (cas d'une cible monophasique).

Les étapes a) et b) de CSS peuvent être réalisée dans un four de sublimation à faible distance.

Un four à lampe peut être utilisé pour réaliser ces étapes.

Par exemple, comme représenté sur les figures 1A, 1B et en particulièrement détaillé sur la figure 3, le four CSS 100 comprend un réacteur 102 autour duquel est positionné un système de chauffage. Par exemple, il peut s'agir de lampes 104 ou de toute autre système de chauffage (résistance, induction par exemple).

Le réacteur 102 peut être en quartz, en graphite, en métal.

Le réacteur 102 peut être tubulaire.

Le four 100 comprend également un suscepteur 106 (aussi appelé bloc source) et un couvercle 108 (aussi appelé bloc substrat). Le suscepteur 106 et le couvercle 108 sont en des matériaux thermiquement conducteurs, pouvant résister à la pression, au vide et à de fortes températures. Ils sont, de préférence, en graphite.

Le substrat 10 et les précurseurs 21, 22 sont positionnés entre le suscepteur 106 et le couvercle 108.

De préférence, le substrat 10 est en contact direct avec le couvercle 108 qui maintient sa température à la valeur de consigne.

Les précurseurs 21, 22 disposée sur le suscepteur 106.

Le substrat 10 est à faible distance des précurseurs 21, 22. Par faible distance, on entend une distance typiquement de 0,05 mm à 20 mm, voire de 0,1 à 20 mm, préférentiellement de 1 mm à 7mm, par exemple de 1 mm à 5 mm ou de 3 mm à 5 mm pour l'étape a) et préférentiellement de 0.1 mm à 5 mm pour l'étape b). Notamment, on pourra choisir une distance de 1 mm ou de 5 mm. On choisira un compromis entre une distance suffisamment proche pour avoir une vitesse de dépôt élevée et une distance suffisante pour pouvoir maximiser et maintenir le gradient thermique au cours du dépôt.

Un ou plusieurs espaceurs 112 pouvant être en un matériau isolant thermique (par exemple verre, quartz, ou alumine) servent à maintenir le substrat 10 à faible distance de la poudre 20.

Le couvercle 108 peut être maintenu plaqué sur le substrat 10 par un système de fermeture dans le suscepteur 106 non représenté (par exemple une vis ou tout autre système de fixation).

Le suscepteur 106 et le couvercle 108 possèdent chacun un thermocouple 114 ou tout autre système (pyromètre, ...) pour mesurer et piloter leur température.

Un système de chauffage (lampe, résistances, induction ...) permet de réguler la température du suscepteur 106 (Tcible) et du couvercle 108 (Tsubstrat) dans une gamme pouvant aller de 20°C à 600°C. Des rampes de montée en température sont pilotables dans une gamme, par exemple, de 0,1°C/s à 10°C/s. Le suscepteur 106 (Tcible) et le couvercle 108 (Tsubstrat) peuvent être piloté par des rampes (ou séquences de rampes) de température, de manière indépendante. Ainsi, il est possible d'ajuster les cinétiques de sublimation de la poudre 20 et les températures de réaction avec la couche inorganique déposée sur le substrat 10 de façon à contrôler la morphologie de la couche et/ou la durée du procédé.

Il est possible d'ajouter des dispositifs de refroidissement spécifique pour le couvercle 108 (par exemple, tuyauterie intégrée pour liquide de refroidissement, écran de protection contre le rayonnement du suscepteur, radiateurs.

Le dispositif 100 est relié à un système à une arrivée de gaz inerte 116 (tel que de l'argon ou N₂).

Le dispositif 100 peut également être relié à une arrivée de gaz oxydant (tel que O₂) ou à une arrive de gaz réducteur (tel que H₂) .

Le dispositif 100 comprend une sortie de gaz 122, reliée à un système de pompage permettant d'atteindre un vide Pfour allant, par exemple, de 0,00001 Pa - 1 Pa. La valeur Pfour dépend du four CSS utilisé.

Le dépôt par sublimation se fait en chauffant le suscepteur 106 et le couvercle 108 sous vide (typiquement entre 0,01 et 100Pa, par exemple 1Pa), de manière à sublimer les précurseurs organiques ou inorganiques.

Dans le cas de l'étape a) du dépôt par CSS, la température du substrat Tsub est inférieure à la température de la cible Tcible afin de créer un gradient thermique. Le substrat est, avantageusement, maintenu à une température contrôlée. Il en va de même pour la cible.

Dans le cas de l'étape a) du dépôt par CSS, la différence de température Tcible - Tsub est de 10°C à 350°C, de préférence de 50°C à 300°C et encore plus préférentiellement de 50°C à 200°C, par exemple de 100°C.

Lors de l'étape b), la température de la cible peut être identique à la température du substrat.

Selon une variante de réalisation, lors de l'étape b), la température du substrat Tsub est, avantageusement, inférieure à la température de la cible Tcible afin de créer un gradient thermique tout en favorisant une plus grande pression partielle de composé organique sans risquer de décomposer la pérovskite. La différence de température Tcible - Tsub est de 1°C à 350°C (par exemple de 1 à 100°C, notamment 20°C), de préférence de 50°C à 300°C et encore plus préférentiellement de 100°C à 250°C, par exemple de 150°C.

Selon une autre variante de réalisation, lors de l'étape b), Tcible < Tsubstrat pour favoriser la condensation de la vapeur sur le substrat et ainsi accélérer la réaction. La différence de température peut être de 1 à 100°C, par exemple 20°C.

Les températures visées dépendent du matériau à sublimer.

On peut effectuer, par exemple, des rampes de montée en température comprises entre 0,2°C/s et 10°C/s, par exemple de 1°C/s.

Selon une autre variante particulièrement avantageuse, l'étape a) et l'étape b) sont mises en oeuvre par CSVTD (figures 2A et 2B).

Comme représenté sur les figures 2A et 2B, dans le cas d'une étape par CSVTD, les précurseurs 23, 24 peuvent être positionnés dans un creuset 25. Le substrat 10 est positionné en regard du creuset 25. Il est également possible de faire défiler le substrat 10 par rapport au creuset 25.

L'utilisation de creusets permet d'envisager de chauffer les précurseurs inorganiques ou les précurseurs organiques jusqu'à leur température de fusion voire au-delà de leur température de fusion pour accélérer les flux de matière (vitesse de dépôt des précurseurs inorganiques ou pression partielle de la partie organique).

Le réacteur CSVTD est, par exemple, un tube en quartz. Le système de chauffage peut être équipé de lampes 104, ou encore de résistance chauffante.

Le substrat 10 et le creuset 25 peuvent être chauffés indépendamment l'un de l'autre par des lampes ou tout autre système de chauffage (résistance par exemple).

Les précurseurs 23, 24 peuvent être à l'état liquide ou à l'état solide. Ainsi, en fonction de l'état du précurseur (liquide ou solide), l'étape CSVTD peut être mise en oeuvre par évaporation ou par sublimation, respectivement.

Lorsque les précurseurs sont à l'état solide, ils peuvent être sous la forme de poudres obtenues par mécanosynthèse.

La mise en oeuvre d'une CSVTD permet soit de former une couche 11 sur le substrat 10 à partir des précurseurs inorganiques 23 (étape a)) soit de faire réagir les vapeurs des précurseurs organiques 24 avec la couche 11 de précurseurs inorganiques pour former la couche de pérovskite 12 (étape b)).

La température du substrat Tsub mises en oeuvre dans le procédé (i.e. lors de l'étape a) et/ou lors de l'étape b)) sont, avantageusement, inférieures à 250°C et encore plus avantageusement inférieures à 200°C

Dans les différentes variantes de réalisation précédemment décrites, la chambre de dépôt utilisée pour l'étape a) et la chambre de dépôt utilisée pour l'étape b) peuvent être identiques ou différentes.

De manière avantageuse, des chambres différentes sont utilisées et le procédé est réalisé en continu en mettant en oeuvre l'étape a) dans une première chambre et l'étape b) dans une deuxième chambre.

La mise en oeuvre d'étape par CSS ou par CSVTD autorise un défilement du substrat d'une chambre à l'autre pour être en contact successivement avec les précurseurs inorganiques puis avec les précurseurs organiques.

La nature du substrat est intimement liée à l'application visée. Le substrat peut être un substrat en verre, en polymère (polyimide par exemple), en acier. De préférence, il est en silicium. Le substrat en silicium peut être texturé ou non texturé. Il peut être poli.

Avantageusement, le substrat est fonctionnalisé avec une couche ou un empilement de couches isolantes, conductrices et/ou semi-conductrices pour injecter et/ou collecter des charges dans le matériau pérovskite.

Les couches obtenues par un tel procédé sont homogènes et continues.

De préférence, les précurseurs inorganiques 21, 23 sont choisis parmi des matériaux suivants : CsCl, CsBr, CsI, PbCl₂, PbBr₂ et PbI₂, avec, préférentiellement au moins un halogénure de Cs et un halogénure de Pb. Il peut s'agir d'une combinaison de deux, de trois ou plus de trois précurseurs.

Par exemple, les précurseurs inorganiques 21, 23 sont choisis parmi l'une des combinaisons suivantes : une combinaison de deux matériaux comme PbI₂ et CsI, PbI₂ et CsBr, PbBr₂ et CsI, PbBr₂ et CsBr, ou encore une combinaison de trois matériaux PbI₂, PBBr₂ et CsI ou PbI₂, PBBr₂ et CsBr ou PbI₂, CSI et CsBr ou PbBr₂, CSI et CsBr ou PbBr₂, PbI₂, CSI et CsBr. De préférence, il s'agit de PbI₂ et CsBr.

Par exemple, les précurseurs organiques 22, 24 sont FA(I_{1-y}Br_{y}) ou MA(I_{1-y}Br_{y}) avec 0 < y < 1. De tels précurseurs peuvent être obtenus, par exemple, par mécanosynthèse à partir de poudres de FABr et de FAI ou à partir de poudres de MABr et de MAI. Les précurseurs organiques MA(I_{1-y}Br_{y}) peuvent servir pour former des couches de Cs₁₋ₓMAₓPb(I_{1-y}Br_{y})₃. Les précurseurs organiques FA(I_{1-y}Br_{y}) peuvent servir pour former des couches 12 de Cs₁₋ₓFAₓPb(I_{1-y}Br_{y})₃.

Selon un autre exemple, les précurseurs organiques 22, 24 peuvent être MA₂FA₁₋₂I_{1-y}Br_{y} (avec 0<z<1 et 0<y<1) . Ils peuvent être obtenus par mécanosynthèse à partir de poudres de MABr et/ou MAI et/ou FABr et/ou FAI. Ces précurseurs peuvent être utilisés pour former des couches 12 de CsₓMA_{z}FA_{1-z-x}Pb(I_{1-y}Br_{y})₃.

Selon un autre exemple, les précurseurs organiques 22, 24 sont FAI_{1-y-z}Br_{y}Cl_{z} (avec 0<y<1 et 0<z<1) . Ils peuvent être obtenus à partir de poudres de FAI et/ou FABr et/ou FACl. Ils peuvent servir à former des couches 12 de Cs₁₋ₓFAₓPb(I_{1-y-z}Br_{y}Cl_{z})₃.

Les couches de pérovskite obtenues peuvent être utilisées dans de nombreux domaines industriels, en particulier, dans le domaine de la détection X pour le médical, la sûreté, la sécurité, la radioprotection, ou les grands instruments scientifiques, mais aussi dans le domaine du photovoltaïque, de la détection de rayonnement gamma, de rayonnements ionisants (alpha, beta, neutron) ou encore pour la fabrication de dispositifs électroniques, optiques ou optoélectroniques, en particulier pour la fabrication de diodes électroluminescentes (DEL), de photo-détecteurs, de scintillateurs ou encore de transistors.

En particulier, le procédé s'applique pour déposer des pérovskites hybrides organiques inorganiques de faibles épaisseurs (comprises entre 10 nm et 5000 nm). Ces matériaux sont généralement utilisés pour les applications optiques visible ou proche infra-rouge. On citera notamment les applications photovoltaïques, mais aussi la détection infra-rouge et proche infrarouge ou l'émission de lumière dans les longueurs d'onde visible, proche infra-rouge et infra rouge.

En particulier, en ce que qui concerne les applications photovoltaïques, le procédé précédemment décrit peut être utilisé pour élaborer une couche de matériau pérovskite hybride organique-inorganique dans une cellule photovoltaïque.

En jouant sur la quantité d'iode, de brome et de chlore dans le matériau pérovskite, il est possible de modifier l'énergie de bande interdite.

Les cellules photovoltaïques peuvent être des cellules simples jonctions ou des cellules multi-jonction.

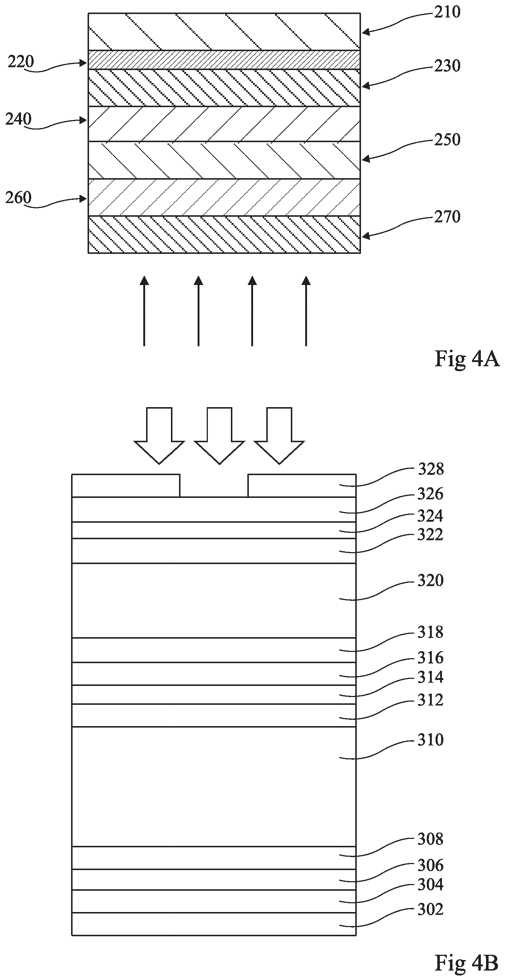

Par exemple, une cellule photovoltaïque simple jonction de type p-i-n, peut comprendre depuis la face arrière vers la face avant (figure 4A) :
- une électrode supérieure 210,
- une couche tampon 220,
- une couche de type n 230,
- une couche active en pérovskite 240,
- une couche de type p 250,
- une couche d'oxyde transparent conducteur 260,
- un substrat 270.

De préférence, la cellule photovoltaïque est constituée des différents éléments cités ci-dessus.

La face avant de la cellule photovoltaïque est destinée à recevoir un flux lumineux.

Le rayonnement incident est représenté par des flèches sur la figure 4A.

L'électrode supérieure 210 est, par exemple, en Ag, Cu, Ni, Al. Elle a, par exemple, une épaisseur comprise entre 50 et 300 nm.

La couche tampon 220 a une épaisseur comprise entre 1nm et 5nm, de préférence entre 3 et 4 nm. Elle est, avantageusement, continue et conforme. Elle est contact direct avec la couche de type n.

Il peut s'agir d'une couche en LiF, SnS, en oxyde métallique, en BCP (bathocuproine) ou encore en alumine de formule Al₂O₃ ou de formule AlOx avec x compris entre 0,8 et 1,5.

La couche de type n 230 peut être par exemple en C60, PC61BM ([6,6]-phényl-C61 -butanoate de méthyle ou « [6,6]-phenyl-C61-butyric acid methyl ester »), PC71BM ([6,6]-phényl-C71-butanoate de méthyle ou « [6,6]-phenyl-C71-butyric acid methyl ester »), PCBM/C60 ou PCBM/C. De préférence, elle est en C60. La couche de type n 230 a, par exemple, une épaisseur comprise entre 5 et 50 nm.

Selon d'autres variantes de réalisation, la couche de type n 230 peut être une couche d'oxyde, par exemple SnOx (avec x compris entre 1 et 2), ZnO, Al :ZnO, ITO ou IZO.

De telles couches ont une épaisseur entre 5 et 30 nm.

La couche active 240 est une couche active en pérovskite obtenue par le procédé précédemment décrit. De préférence la couche de pérovskite est une pérovskite de type APbX₃ avec A représentant des cations de méthylammonium, diméthylammonium, formamidinium, guanidinium ou césium (les cations précités peuvent être utilisés seuls ou en mélange) et X représentant des anions halogénures (de préférence des anions chlore, brome, iode seuls ou en mélange).

La couche active 240 a, par exemple, une épaisseur comprise entre 200 nm et 1,5 µm.

Selon une première variante, la couche de type p 250 peut être une couche de poly(3,4-éthylènedioxythiophène) (PEDOT) ou de poly[bis(4-phényl) (2,4,6-triméthylphényl)amine (PTAA). Elle peut avoir une épaisseur entre 5 et 50 nm.

Selon une deuxième variante, la couche de type p 250 est une couche autoassemblée (ou SAM pour « Self-Assembled Monolayer »). La couche de SAM peut être une couche de 2PACz (acide [2-(9H-Carbazol-9-yl)éthyl]phosphonique), 3PACz (acide 3-(9H-carbazol-9-yl)propyl)phosphonique), 4PACz (acide 4-(9H-carbazol-9-yl)butyl)phosphonique), Me-4PACz (acide (4-(3,6-Diméthyl-9H-carbazol-9-yl)butyl)phosphonique), MeO-2PACz (acide (2-(3,6-Diméthoxy-9H-carbazol-9-yl)éthyl)phosphonique), 6dPA (acide 1,6-hexylènediphosphonique) ou encore une couche de MPA (acide méthylphosphonique)ou une couche obtenue à partir d'un mélange de ces molécules. Il peut également s'agir d'un de leurs dérivés. Des additifs peuvent églement être ajoutés. Les molécules de la couche SAM ont, avantageusement, une fonction permettant de s'ancrer sur la couche d'oxyde sous-jacente. Une telle couche de type p 250 peut avoir une épaisseur entre 1 et 5 nm.

Selon une troisième variante, la couche de type p 250 est une couche d'oxyde, par exemple une couche de MoOₓ (ayant par exemple une épaisseur entre 5 et 30 nm), une couche de NiOₓ (ayant par exemple une épaisseur entre 1 et 30 nm).

Selon une autre variante, la couche de type p 250 peut être un bicouche oxyde/SAM, par exemple un bicouche NiOₓ/SAM.

La couche d'oxyde transparent conducteur 260 a, par exemple, une épaisseur comprise entre 50 et 300 nm. De préférence, il s'agit d'oxyde d'indium-étain (ou ITO).

Ces différents éléments sont positionnés sur un substrat 270 disposé en face arrière. Le substrat 270 est, par exemple, en verre.

Par exemple, la cellule photovoltaïque comprend depuis la face arrière vers la face avant :
- une électrode supérieure 210 en argent,
- une couche tampon en alumine 220,
- une couche de type n 230 en C60,
- une couche active 240 en FA_{0.83}Cs_{0.17})Pb(I_{0.6}Br_{0.4})₃,
- une couche de type n 250 en 2PACz,
- une couche d'oxyde transparent conducteur 260 en ITO,
- un substrat, de préférence en verre 270.

Par exemple, une cellule photovoltaïque tandem peut comprendre une sous-cellule inférieure en Silicium (Si) et une sous-cellule supérieure en pérovskite (PK).

Une telle cellule est par exemple représentée sur la figure 4B. Cette structure est dite de type « inverse » ou p-in. La cellule comprend depuis la face arrière vers la face avant :
- une première électrode 302,
- une première couche d'oxyde transparent conducteur 304, par exemple en ITO ou AZO,
- une couche de silicium amorphe dopé p 306,
- éventuellement une couche de silicium amorphe intrinsèque 308,
- une couche active en silicium cristallin 310,
- éventuellement une couche de silicium amorphe intrinsèque 312,
- une couche de silicium amorphe dopé n 314,
- une deuxième couche d'oxyde transparent conducteur 316, par exemple en ITO ou AZO,
- une couche de type p (HTL) 318, par exemple en PEDOT, PTAA, ou encore en oxyde (MoOₓ ou NiOₓ par exemple) ou formée d'une SAM,
- une couche active en pérovskite 320, par exemple de formule APbX₃,
- une couche de passivation par exemple MgFx, AlOx, LiF,
- une couche de type n (ETL) 322, par exemple en C₆₀,
- une couche tampon 324, par exemple en BCP ou en oxyde comme SnOₓ,
- une troisième couche d'oxyde transparent conducteur 326, par exemple en ITO ou AZO,
- une deuxième électrode 328, par exemple en Ag, Cu, Ni ou Al.

Les différents matériaux utilisés pour la sous-cellule supérieure en pérovskite (PK) peuvent être par exemple choisis parmi les matériaux précédemment décrits pour la cellule simple jonction.

La méthode de dépôt par CSS est particulièrement adaptée pour former des cellules solaires à base de pérovskite sur une cellule inférieure en Si. La cellule inférieure peut présenter une surface texturée (par exemple, une surface sous la forme de pyramides de 1 à 2 µm de hauteur). Dans le cas de cellules tandem sur Si, il pourra en particulier s'agir de la pérovskite Cs₁₋ₓFAₓPb(I_{1-y}Br_{y})₃ avec 0, 65<x<0,9 (de préférence x~0,8) et y~0,3. Le taux de Br peut être facilement ajusté pour obtenir une bande d'énergie interdite à 1,7 eV (soit 0,2 < y < 0,4) .

Pour les applications photovoltaïques, le procédé d'élaboration de couche de pérovskite peut également être utilisée pour fabriquer les cellules solaires simples jonctions à base de pérovskite. Dans ce cas, la pérovskite aura une énergie de bande interdite comprise entre 1,3 eV et 1,5 eV. Il pourra en particulier s'agir de la pérovskite Cs₁₋ₓFAₓPb(I_{1-y}Br_{y})₃ avec x~0,85 et 0,05 < y < 0,25.

Il est également possible de fabriquer une cellule tandem pérovskite (1,2 eV) / pérovskite (1,8 eV) en déposant une première pérovskite en Cs₁₋ₓFAₓPb_{0.5}Sn_{0.5}(I_{1-y}Br_{y})₃ avec x~0,85 et y~0, 05 et une seconde en Cs₁₋ₓFAₓPb(I_{1-y}Br_{y})₃ avec x~0, 85 et y~0,5. L'une des couches de pérovskite ou les deux couches de pérovskite peuvent être formées selon le procédé précédemment décrit.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

### Exemple illustratif et non limitatif d'un mode de réalisation particulier de l'invention

Dans cet exemple, une couche de pérovskite hybride organique-inorganique de formule CsₓFA₁₋ₓPb(I_{1-y}Br_{y})₃ avec x~0,8 et y~0,2 a été élaborée. La couche a une épaisseur de 300 nm.

Préparation de la première cible pour la première étape de dépôt par CSS et dépôt des précurseurs inorganiques à partir de cette première cible

La première cible est fabriquée à partir de précurseurs de Pb et Cs. En particulier, les précurseurs sont des halogénures de Pb et de Cs, choisis parmi, d'un part, PbI₂ et PbBr₂, et, d'autre part, CsI et CsBr.

La poudre compactée à l'aide d'une presse hydraulique (P ~ 1×10⁷ Pa). Elle forme une galette solide de dimensions latérales identiques à celles du dépôt que l'on veut réaliser. Elle a une épaisseur d'environ 0,5 mm. La masse de la poudre pour fabriquer la cible est calculée à partir de ses dimensions, de la densité de la poudre et de la compacité de la galette (environ 0,8 pour cette valeur de pression).

Par exemple, pour une cible de PbI₂ + 40at% CsBr de 3 cm², on utilisera environ 0,4 g de poudre.

Il est également possible d'obtenir une poudre formée de particules, en un même matériau, en effectuant un cobroyage du PbI₂ et du CsBr. On obtient ainsi un mélange très homogène. Cette étape est facultative.

Par exemple, la poudre peut être fabriquée en cobroyant dans une broyeuse planétaire pendant 1h à 500 tours/min (rpm) sous atmosphère neutre (Ar ou N₂) le PbI₂ avec 40 at% de CsBr. Ce broyage est effectué dans un bol en carbure de tungstène avec des billes en carbure de tungstène et un rapport massique m_{poudre}/m_{billes} < 0,2.

Le dépôt des précurseurs inorganiques est réalisé par CSS à partir de la première cible.

Le dépôt par CSS peut se faire dans un four de recuit dans lequel le substrat sur lequel on veut faire le dépôt est placé en vis-à-vis de la cible du matériau que l'on souhaite déposer.

Le substrat est ici une cellule solaire à hétérojonction en silicium qui présente une surface texturée recouverte d'une électrode en ITO et d'une couche d'injection de charges de type SAM (« Self-Assembled Monolayer »).

Le substrat est placé à faible distance de la cible. Typiquement, une faible distance est une distance comprise entre 0,1 et 10 mm. Par exemple, une distance d'environ 5 mm est choisie.

L'ensemble est sous vide, typiquement la pression peut être comprise entre 0,01 Pa et 100 Pa. Par exemple, la pression est de 1 Pa.

Un système de chauffage permet de chauffer indépendamment la cible et le substrat. La cible est chauffée à une température suffisante pour qu'elle se sublime et en dessous de sa température de fusion. Le substrat est chauffé à une température inférieure à celle de la cible (inférieure de 10°C à 300°C, typiquement inférieure de 100°C).

Le système de chauffage est assuré par un suscepteur et un couvercle en graphite contre lesquels sont plaqués la cible et le substrat respectivement pour assurer leur thermalisation. Le système de chauffe retenu est un système à lampe. Tout autre système de chauffe (chauffe résistive, à induction) pour chauffer un système de suscepteur / couvercle en matériau conducteur thermique (graphite ou autre) ou un système chauffant directement cible et substrat en contrôlant leur température est envisageable.

Le matériau de la cible se sublime et se condense sur le substrat.

Le temps de dépôt et les températures conditionnent l'épaisseur du dépôt.

L'épaisseur de la pérovskite finale est fonction de l'épaisseur de la couche de précurseurs inorganiques déposés par CSS.

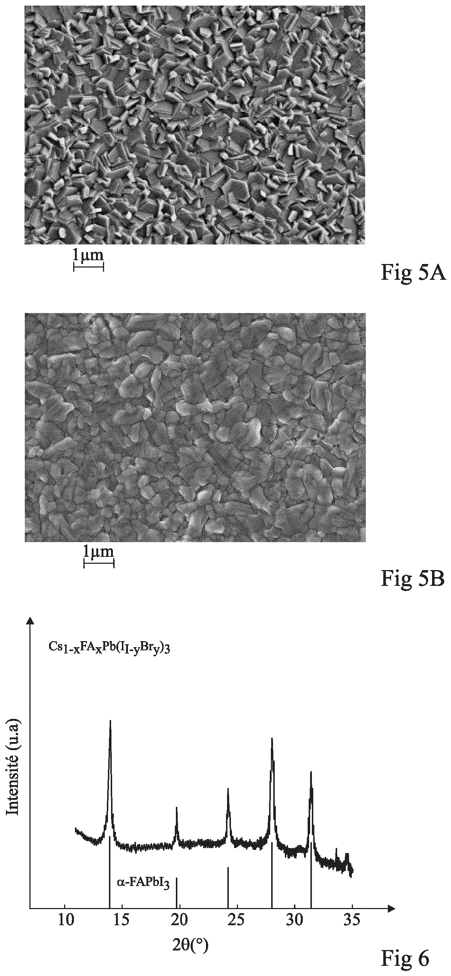

Par exemple, pour synthétiser une couche de pérovskite ayant une épaisseur de 300 nm, une couche de précurseurs inorganiques (à partir d'une cible de PbI₂ + 40 at% CsBr) d'environ 250 nm peut être déposée (figure 5A). La cible peut être, par exemple, chauffée à 270°C et le substrat à 170°C pendant une durée de 5 min.

La distance cible substrat est de 5 mm et la pression de 1 Pa.

Préparation de la deuxième cible pour la deuxième étape de dépôt par CSS et formation de la couche de pérovskite à partir de cette deuxième cible.

Ce deuxième dépôt va permettre de transformer les précurseurs inorganiques en pérovskite. La deuxième cible pour le dépôt CSS apporte donc les éléments organiques de la pérovskite. Ici, il s'agit du FA (CH₅N₂) ou du MA (CH₃NH₃) .

La deuxième cible comprend des halogénures de FA. La cible est une cible solide, obtenue à partir d'une poudre compactée de FAI 50at% + FABr 50 at%. Les conditions pour fabriquer la deuxième cible solide sont identiques à celles utilisées pour fabriquer la première cible.

Le type d'équipement CSS utilisé est le même que celui utilisé pour le premier dépôt. Le substrat comprenant les précurseurs inorganiques est positionné en vis-à-vis et à faible distance et sous vide de la cible de CSS.

Cette étape n'est pas une étape de dépôt : il ne s'agit pas de transférer de la matière de la cible au substrat, mais il s'agit plutôt d'une étape de recuit des précurseurs présents sur le substrat sous atmosphère générée par la sublimation de la deuxième cible. Par conséquent, la cible et le substrat peuvent être maintenus à la même température ou à des températures différentes.

Pour une température donnée, la durée de cette étape est ajustée pour que la totalité des précurseurs présents sur le substrat ait réagi. On veillera à ne pas dépasser cette durée au risque de dégrader la pérovskite (sur-réaction).

Par exemple, pour une couche de précurseurs de 250 nm contenant PbI2 et 40 at% CsBr, et une cible solide comprenant FAI 50at% et FABr 50 at%, la cible et le substrat sont chauffés à 140°C pendant une durée de 15 min pour une distance cible substrat de 5 mm et sous une pression de 1 Pa. La couche de pérovskite obtenue est représentée sur la figure 5B.

La couche de pérovskite a été caractérisée par diffraction des rayons X (figure 6). La couche de pérovskite correspond bien au matériau Cs₁₋ₓFAₓPb(I_{1-y}Br_{y})₃ avec x~0,9 et y~0,2.

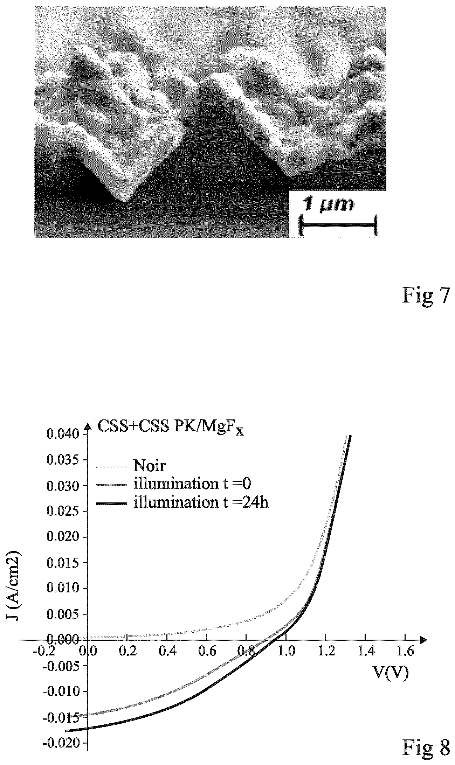

Une observation en coupe (figure 7) confirme que, même pour un substrat texturé, la couche obtenue est conforme et continue.

La cellule photovoltaïque obtenue a été testée au moyen d'une courbe courant-tension dans le noir sous un éclairement AM1, 5 à t=0 et à t=24h (figure 8). La cellule photovoltaïque comprenant une couche de pérovskite obtenue avec un tel procédé présente de bonnes propriétés.

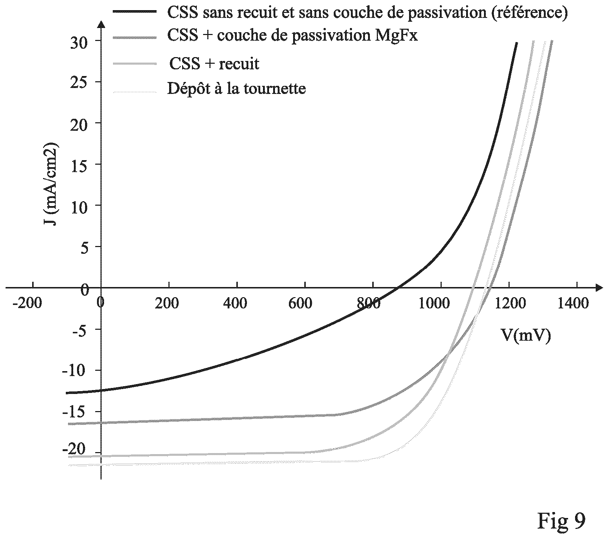

L'influence de la présence d'une couche de passivation en MgFx et d'un recuit thermique à 150°C pendant 20 min à l'air dans une cellule simple jonction a également été étudiée (figure 9). La couche de pérovskite organique-inorganique est élaborée avec le procédé en deux étapes précédemment décrit (courbe notée CSS + recuit) . La cellule photovoltaïque obtenue présente de très bonnes performances. Ces performances sont comparables à celles obtenues pour une cellule photovoltaïque comprenant une couche de pérovskite organique-inorganique préparée par dépôt à la tournette (courbe 'dépôt à la tournette'). La technique de dépôt à la tournette est une technique de dépôt difficilement industrialisable pour de telles applications. Son remplacement par des dépôts CSS/CSVTD successifs est donc particulièrement intéressant.

## Revendications

1. Procédé d'élaboration d'une couche de matériau pérovskite hybride organique-inorganique comprenant les étapes suivantes :
a) Formation d'une couche (11) comprenant les précurseurs inorganiques du matériau pérovskite sur un substrat (10) par CSS ou CSVTD,
b) Mise en oeuvre d'une étape de CSS à partir d'une poudre de précurseurs organiques (22), moyennant quoi les précurseurs organiques (22) réagissent avec la couche (11) de précurseurs inorganiques et on obtient une couche (12) de matériau pérovskite hybride organique-inorganique,
la poudre de précurseurs organiques (22) étant obtenue par mécanosynthèse en cobroyant au moins un premier groupe de particules en un premier matériau et un deuxième groupe de particules en un deuxième matériau, jusqu'à former un troisième groupe de particules en un troisième matériau, le troisième groupe de particules formant la poudre de précurseurs organiques (22) .

2. Procédé selon la revendication 1, **caractérisé en ce que** la pérovskite hybride organique-inorganique a pour formule A'₁₋ₓAₓBX₃ avec _{:}
A' un cation inorganique ou un alliage de cations inorganiques, choisis parmi Cs, Rb, K et Na,
A un cation organique monovalent ou un alliage de cations organiques monovalents, de préférence choisis parmi le méthylammonium, le formamidinium, le guanidinium, le diméthylammonium et l'imidazolium, encore plus préférentiellement A correspond à MA et/ou FA,
B un cation inorganique ou un alliage de cations inorganiques choisis parmi Pb, Sn et Ge,
X un ou plusieurs halogènes choisis parmi Cl, Br, I et F.

3. Procédé selon l'une des revendications 1 et 2, **caractérisé en ce que** la pérovskite hybride organique-inorganique a pour formule Cs₁₋ₓMAₓPb(I_{1-y}Br_{y})₃, Cs₁₋ₓFAₓPb(I_{1-y-z}Br_{y}Cl_{z})₃, Cs₁₋ₓFAₓPb(I_{1-y}Br_{y})₃, Cs₁₋ₓFAₓPb_{0.5}Sn_{0.5}(I_{1-y}Br_{y})₃, Cs_{1-x-z}MAₓFA_{z}Pb(I_{1-y}Br_{y})₃ ou Cs_{1-x-z}MAₓFA_{z}Pb₁₋ₖSnₖ(I_{1-y}Br_{y})₃ avec 0 ≤ y ≤ 1, 0 ≤ k ≤ 1, 0 ≤ x ≤ 1, 0 ≤ z ≤ 1 et 0 ≤ x+z ≤ 1.

4. Procédé selon l'une quelconque des revendications précédentes, **caractérisé en ce que** la couche (11) comprenant les précurseurs inorganiques est une couche contenant du Pb, du Cs et un ou plusieurs halogènes choisis parmi l'iode, le brome et le chlore.

5. Procédé selon l'une quelconque des revendications précédentes, **caractérisé en ce que** les précurseurs organiques sont FA(I_{1-y}Br_{y}) ou MA (I_{1-y}Br_{y}) avec 0 < y < 1.

6. Procédé selon l'une quelconque des revendications 1 à 5, **caractérisé en ce que** l'étape a) et l'étape b) sont réalisées par CSS.

7. Procédé selon l'une quelconque des revendications précédentes, **caractérisé en ce que** le substrat (10) est un substrat en verre, en plastique, en métal ou en silicium, de préférence un substrat en silicium texturé.

8. Procédé de fabrication d'une cellule photovoltaïque pérovskite à simple jonction ou d'une cellule photovoltaïque multi-jonction comprenant au moins une cellule photovoltaïque en pérovskite, par exemple une cellule photovoltaïque tandem pérovskite-silicium, une cellule photovoltaïque tandem pérovskite-pérovskite, une cellule photovoltaïque triple jonction pérovskite-pérovskite-silicium ou une cellule photovoltaïque triple jonction pérovskite-pérovskite-pérovskite, le procédé comprenant l'élaboration d'une couche de pérovskite organique-inorganique selon le procédé selon l'une quelconque des revendications 1 à 7.
